# EUROPEAN PATENT APPLICATION

(11) **EP 4 180 830 A1**
(43) Date of publication of application: **17.05.2023**
(21) Application number: 21306588.1
(22) Date of filing: 16.11.2021
(51) Int. Cl.: G01R 31/396

(54) **FAULT TOLERANT REDUNDANT BATTERY CELL VOLTAGE MEASUREMENT SYSTEM**

(71) Applicant: NXP USA, Inc., Austin TX 78735 (US)
(72) Inventor: BOSVIEUX, Tristan, 31023 Toulouse (FR); CASSAGNES, Thierry Dominique Yves, 31023 Toulouse (FR); HOUT-MARCHAND, Alexis Nathanael, 31023 Toulouse (FR)
(74) Representative: Hardingham, Christopher Mark

(57) **Abstract**

Fault tolerant battery cell voltage measurement systems and methods of operating fault tolerant battery cell voltage measurement systems are provided for measuring the voltages of a plurality of battery cells. The systems include a plurality of analog to digital converters, a plurality of switches coupled to the plurality of analog to digital converters, and a controller. Voltage measurement redundancy is provided by measuring the voltage of each battery cell using two different analog to digital converters within a plurality of voltage measurement phases. The voltages of each battery cell as redundantly measured within the first and second voltage measurement phases may be compared to identify a faulty analog to digital converter.

## Description

### FIELD OF THE DISCLOSURE

The present disclosure relates to battery management systems, and more specifically to fault tolerant battery cell voltage measurement systems and methods of operating fault tolerant battery cell voltage measurement systems.

### BACKGROUND OF THE DISCLOSURE

Battery management systems (BMS) can be implemented in a variety of applications, such to monitor and control battery cells for a variety of applications. For example, battery management systems can be used in high-voltage battery pack applications, including automotive applications such as hybrid electric and electric vehicles, and industrial applications such as energy storage systems and uninterruptible power supply systems.

Traditional voltage monitoring schemes for battery cells use measurement pins (CTs) that are separated from the voltage balancing pins (CBs) for each battery cell. Usage of a package with a large pins number is required. This constraint limits the number of cells that can be monitored by one battery management system device.

Additionally, conventional battery management systems are not fault tolerant. Accordingly, when an error occurs in the voltage monitoring of the cells by a conventional battery management system, the battery pack must be taken offline, because it is unknown whether the fault is with the battery cells or the monitoring system. There are significant costs associated with replacing, refurbishing, or conducting maintenance on a battery pack.

For at least one or more of these reasons, or one or more other reasons, it would be advantageous if new or improved systems could be developed, and/or improved methods of operation or implementation could be developed, so as to address any one or more of the concerns discussed above or to address one or more other concerns or provide one or more benefits.

### BRIEF DESCRIPTION OF THE DRAWINGS

Specific examples have been chosen for purposes of illustration and description, and are shown in the accompanying drawings, forming a part of the specification.
Figure 1 is a circuit diagram of a first example of a battery cell voltage measurement system during a first voltage measurement phase.
Figure 2 is a circuit diagram of the battery cell voltage measurement system of Figure 2 during a second voltage measurement phase.
Figure 3 is a circuit diagram of a second example of a battery cell voltage measurement system during a first voltage measurement phase.
Figure 4 is a circuit diagram of the battery cell voltage measurement system of Figure 3 during a second voltage measurement phase.
Figure 5 is a circuit diagram of a third example of a battery cell voltage measurement system during a first voltage measurement phase.
Figure 6 is a circuit diagram of the battery cell voltage measurement system of Figure 5 during a second voltage measurement phase.
Figure 7 is a flow diagram of one method of operating fault tolerant battery cell voltage measurement system of the present technology.

While various embodiments discussed herein are amenable to modifications and alternative forms, aspects thereof have been shown by way of example in the drawings and are described in detail herein. It should be understood, however, that the disclosure is not limited to the particular embodiments described, and instead is meant to include all modifications, equivalents, and alternatives falling within the scope of the disclosure. In addition, the terms "example" and "embodiment" as used throughout this application is only by way of illustration, and not limitation, the Figures are not necessarily drawn to scale, and the use of the same reference symbols in different drawings indicates similar or identical items unless otherwise noted.

### DETAILED DESCRIPTION

Fault tolerant battery cell voltage measurement systems and methods of the present technology may be used in battery management systems in a variety of technologies, including but not limited to lithium battery cells used in battery packs for automotive applications. Fault tolerant battery cell voltage measurement systems and methods of the present technology include a plurality of analog to digital converters that measure the voltage of a plurality of battery cells. In examples of fault tolerant battery cell voltage measurement systems as manufactured, prior to installation, the systems may not include the battery cells. However, in examples where fault tolerant battery cell voltage measurement systems have been installed, the systems may include the battery cells.

Fault tolerant battery cell voltage measurement systems and methods of the present technology use a plurality of voltage measurement phases in sequence, and each sequence of the plurality of voltage measurement phases may be cyclically repeated, such as alternating first and second voltage measurement phases, over time, to provide continuous monitoring. Within each sequence of the voltage measurement phases, the voltage of any given battery cell is measured by two different analog to digital converters within the plurality of voltage measurement phases. In other words, at some point during each sequence of the plurality of voltage measurement phases, the voltage of each battery cell is measured by two different analog to digital converters. In the illustrated embodiments described herein, the fault tolerant battery cell voltage measurement systems are each configured such that each battery cell is measured by two analog to digital converters either within a single voltage measurement phase, or by a different analog to digital converter in each of the two voltage measurement phases. It should be understood that, in other embodiments, there may be more than two voltage measurement phases. For example, three measurement phases could be used, and the system could be configured such that each battery cell is measured by three analog to digital a converters either within a single voltage measurement phase, or by one analog to digital converter in each of the three voltage measurement phases. Accordingly, voltage monitoring redundancy is provided for each battery cell, which may enable detection of a single faulty analog to digital converter, or of multiple none-adjacent faulty analog to digital converters. Identification of a faulty analog to digital converter allows measurements by the faulty analog to digital converter to be disregarded while allowing voltage measurement of all of the battery cells to continue.

Voltage monitoring redundancy is provided by fault tolerant battery cell voltage measurement systems of the present technology using a controller and plurality of switches that are coupled to the plurality of analog to digital converters. At least two sets of switches are provided, including a first set of switches and a second set of switches, that are operated by the controller to operatively connect each battery cell to two different analog to digital converters within the plurality of voltage measurement phases. For example, the controller may be configured to close the first set of switches to operatively connect a first subset of the plurality of battery cells to a first subset of the analog to digital converters during a first voltage measurement phase, and to close the second set of switches to operatively connect either the first subset or a second subset of the plurality of battery cells to a second subset of the analog to digital converters during a second voltage measurement phase. Each subset of battery cells may include any number of the plurality of battery cells up to all of the battery cells, such as half of the battery cells, less than all of the battery cells, or all of the battery cells. In some examples, the first subset may include all of the battery cells. In some other examples, the first subset includes a first half of the battery cells, and the second subset includes a second half of the battery cells. Likewise, each subset of analog to digital converters may include any number of the plurality of analog to digital converters up to all of the analog to digital converters, such as all but one of the analog to digital converters, less than all of the analog to digital converters, or all of the analog to digital converters.

During operation of fault tolerant battery cell voltage measurement systems of the present technology, each of the battery cells of the plurality of battery cells is operatively connected to a respective first one of the plurality of analog to digital converters and a respective second one of the plurality of analog to digital converters, either successively during the first and second voltage measurement phases, respectively, or simultaneously during either of the first and second voltage measurement phases. In at least some examples, the voltage of each battery cell may be measured by at least one analog to digital converter during a first voltage measurement phase, and by at least one different analog to digital converter during the second voltage measurement phase. Accordingly, each battery cell may be operatively connected to at least one analog to digital converter, thus providing a connection ratio of 1:1 battery cells to analog to digital converters, during each voltage measurement phase. In such examples, each battery cell is operatively connected to one analog to digital converter during the first voltage measurement phase and to a different analog to digital converter during the second voltage measurement phase. In at least some alternative examples, the voltage of each battery cell is measured by two analog to digital converters during either a first or second voltage measurement phase. Accordingly, each battery cell of a first subset of battery cells may be operatively connected to at least two analog to digital converters during a first voltage measurement phase, and each battery cell of a second subset of battery cells may be operatively connected to at least two analog to digital converters during a second voltage measurement phase. In such examples, the first subset of battery cells and the second subset of battery cells combined equal the total plurality of battery cells. Such arrangements provide in a connection ratio of 1:2 battery cells to analog to digital converters during each voltage measurement phase.

As used herein, the phrase "operatively connect" signifies establishing an electrical connection (or multiple electrical connections) so that one or more voltage measurement operations can be effectively performed by any of the systems described or encompassed herein. Such an electrical connection (or multiple electrical connections) can be established, for example, due to the closing of one or more switches so that input terminals of an analog to digital converter are respectively electrically coupled, directly by way of the one or more switches or alternatively indirectly by way of one or more additional components, to respective terminals of a respective battery cell with respect to which the voltage is being measured. By virtue of such an electrical connection (or multiple electrical connections), the analog to digital converter input terminals are coupled (directly or indirectly) across the battery cell terminals such that the analog to digital converter can in turn generate an output signal based upon or indicative of the voltage output by the respective battery cell. Given such an arrangement, in at least some contexts herein, such switches (e.g., when closed) can be understood to be the device(s) that "operatively connect" battery cells with analog to digital converters as described herein. At the same time, it should further be recognized that, in at least some embodiments encompassed herein, a controller governs or controls the switching statuses of such switches. Given this to be the case, in at least some further contexts herein, such a controller can also be understood to be the device (alone or in combination with the switches) that "operatively connects" the battery cells with analog to digital converters due to the controller's actuation of the switches.

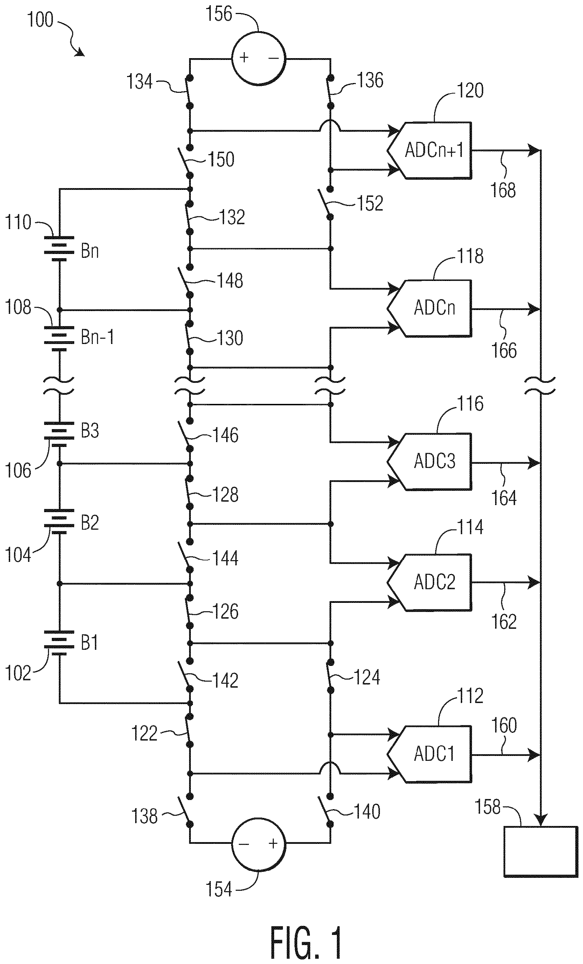

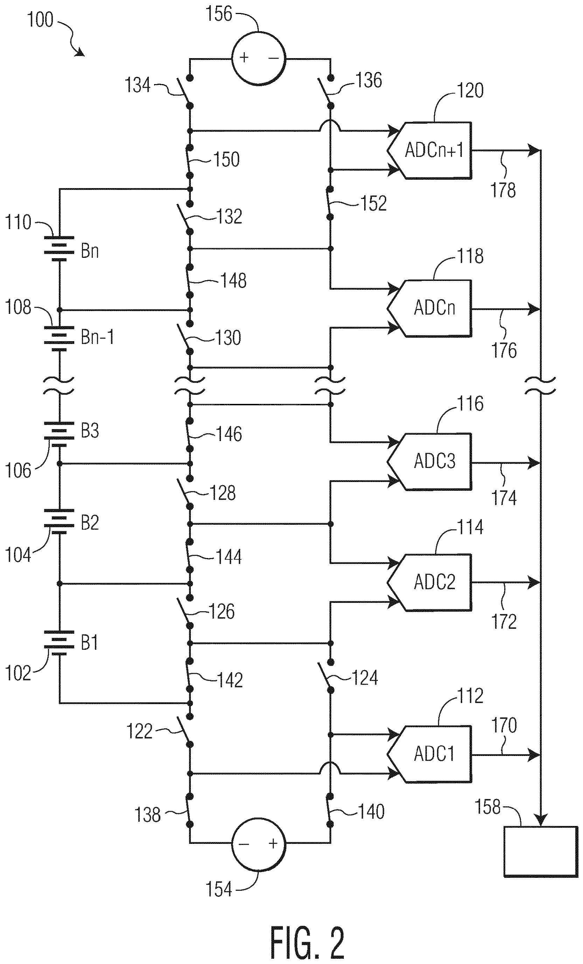

Figures 1 and 2 illustrate one example of a fault tolerant battery cell voltage measurement system 100 of the present technology for measuring the voltage of a plurality of battery cells. Figure 1 shows the fault tolerant battery cell voltage measurement system 100 during a first voltage measurement phase, and Figure 2 shows the fault tolerant battery cell voltage measurement system 100 during a second voltage measurement phase.

Referring to Figures 1 and 2, the fault tolerant battery cell voltage measurement system 100 is shown as installed for use with a plurality of battery cells. The plurality of battery cells may include any suitable number of battery cells, depending upon the embodiment. Conceptually each battery cell of the plurality of battery cells may be identified in sequence from a first battery cell B₁, second battery cell B₂, and so forth, through battery cell Bₙ. In at least some examples, the plurality of battery cells includes at least a first battery cell 102 and a second battery cell 104. In the example of Figures 1 and 2, the plurality of battery cells includes at least first battery cell 102, second battery cell 104, third battery cell 106, fourth battery cell 108, and fifth or final battery cell 110. Each battery cell has a fully charged voltage, which may be any suitable voltage for the given application. In at least some examples, the fully charged voltage of each battery cell may be from about 1.5 volts to about 4.5 volts.

The fault tolerant battery cell voltage measurement system 100 includes a plurality of analog to digital converters. The number of analog to digital converters in the plurality of analog to digital converters is dependent on the number of battery cells in the plurality of battery cells, and is equal to or greater than the number of battery cells in the plurality of battery cells. In the example shown in Figures 1 and 2, the number of analog to digital converters in the plurality of analog to digital converters is equal to the number of battery cells in the plurality of battery cells plus one. Conceptually, in this example, each analog to digital converter of the plurality of analog to digital converters may be identified in sequence from a first analog to digital converter ADC₁, second analog to digital converter ADC₂, and so forth, through analog to digital converter ADCₙ₊₁. The fault tolerant battery cell voltage measurement system 100 includes at least a first analog to digital converter 112, a second analog to digital converter 114, and a third analog to digital converter 116. In the example illustrated in Figures 1 and 2, the plurality of analog to digital converters includes a first analog to digital converter 112, a second analog to digital converter 114, a third analog to digital converter 116, fourth analog to digital converter (not shown), a fifth analog to digital converter 118, and a sixth or final analog to digital converter 120. As shown, conceptually, the fourth analog to digital converter (not shown) would correspond to analog to digital converter ADCₙ₋₁.

The fault tolerant battery cell voltage measurement system 100 uses at least two voltage measurement phases to provide voltage monitoring redundancy through double voltage measurement. Each analog to digital converter is configured to measure the voltage of the battery cell to which it is operatively connected during each voltage measurement phase. In the example as illustrated in Figures 1 and 2, the plurality of battery cells is operatively connected to the plurality of analog to digital converters in a 1: 1 ratio during each of two voltage measurement phases. Accordingly, each battery cell is operatively connected to one analog to digital converter during a first voltage measurement phase, and the analog to digital converter to which each battery cell is operatively connected measures the voltage of that battery cell during the first voltage measurement phase. Similarly, each battery cell is operatively connected to a different analog to digital converter during a second voltage measurement phase, and the different analog to digital converter to which each battery cell is operatively connected measures the voltage of that battery cell during the second voltage measurement phase. In some such examples, within the first and second voltage measurement phases, each battery cell may be alternately monitored by at least two analog to digital converters, where each battery cell shares one monitoring analog to digital converter with the battery cell above it and one monitoring analog to digital converter with the battery cell below it. Alternatively, the plurality of battery cells may be operatively connected to the plurality of analog to digital converters in a different ratio, in which each battery cell may be measured by more than one analog to digital converter during any given voltage measurement phase.

In order to operatively connect the first subset of battery cells to a first subset of analog to digital converters during the first voltage measurement phase and the second subset of battery cells to a second subset of analog to digital converters during the second voltage measurement phase, at least two sets of switches are provided. For example, a first set of switches is configured to be closed to operatively connect each battery cell to one analog to digital converter during the first voltage measurement phase, and a second set of switches is configured to be closed to operatively connect each battery cell to a different analog to digital converter during the second voltage measurement phase. As shown in Figures 1 and 2, the first set of switches in the present embodiment includes switches 122, 124, 126, 128, 130, 132, 134, and 136, and the second set of switches in the present embodiment includes switches 138, 140, 142, 144, 146, 148, 150, and 152. Other arrangements of switches may be used to provide the first set of switches and second set of switches. In the example shown in Figures 1 and 2, the first set of switches, such as switches 122, 124, 126, 128, 130, 132, 134, and 136, and the second set of switches, such as switches 138, 140, 142, 144, 146, 148, 150, and 152, are each configured to, when closed, operatively connect the plurality of battery cells to the plurality of analog to digital converters in a 1: 1 ratio of battery cells to analog to digital converters.

As shown in Figure 1, during the first voltage measurement phase, the first set of switches, when closed, operatively connects each battery cell to an analog to digital converter, such that each battery cell is operatively connected to a separate analog to digital converter. The operative connection may be formed in at least some examples by the controller closing each switch of the first set of switches, and opening each switch of the second set of switches. The first set of switches may operatively connect each analog to digital converter to a battery cell in a first pattern. For example, conceptually, the battery cell B₁ may be operatively connected to the analog to digital converter ADC₁,the battery cell B2 may be operatively connected to the analog to digital converter ADC2, and so forth, with the battery cell Bₙ being operatively connected to the analog to digital converter ADCₙ. Such an arrangement is shown in Figure 1, in which, during the first voltage measurement phase, the first battery cell 102 is operatively connected to the first analog to digital converter 112 by at least a first switch 122 of the first set of switches, and the second battery cell 104 is operatively connected to the second analog to digital converter 114 by at least a second switch 126 of the first set of switches.

Similarly, as shown in Figure 2, during the second voltage measurement phase, the second set of switches, when closed, operatively connects each battery cell to a different analog to digital converter, such that each battery cell is operatively connected to a separate analog to digital converter that is different from the analog to digital converter to which the battery cell was connected to during the first voltage measurement phase. The operative connection may be formed in at least some examples by the controller closing each switch of the second set of switches, and opening each switch of the first set of switches. The second set of switches may operatively connect each battery cell to an analog to digital converter in a second pattern, which is different from the first pattern used during the first voltage measurement phase. For example, conceptually, the battery cell B₁ may be operatively connected to the analog to digital converter ADC₂, the battery cell B₂ may be operatively connected to the analog to digital converter ADC₃, and so forth, with the battery cell Bₙ being operatively connected to the analog to digital converter ADCₙ₊₁. Such an arrangement is shown in Figure 2, in which, during the second voltage measurement phase, the first battery cell 102 is operatively connected to the second analog to digital converter 114 by at least a first switch 142 of the second set of switches, and the second battery cell 104 is operatively connected to the third analog to digital converter 116 by at least a second switch 144 of the second set of switches, etc.

Fault tolerant battery cell voltage measurement systems of the present technology may also include at least one reference voltage. In the example shown in Figures 1 and 2, the fault tolerant battery cell voltage measurement system 100 includes a first reference voltage 154 and a second reference voltage 156. The first reference voltage 154 and the second reference voltage 156 may each serve as control values, providing a consistent known voltage. The voltage of the first reference voltage 154 may be the same as or different from the voltage of the second reference voltage 156.

Referring to the example shown in Figures 1 and 2, because the plurality of analog to digital converters is equal to the plurality of battery cells plus one, during each voltage measurement phase, either the first analog to digital converter 112 or the final analog to digital converter 120 is not operatively connected to a battery cell. The fault tolerant battery cell voltage measurement system 100 may be configured such that the analog to digital converter that is not operatively connected to a battery cell during a given voltage measurement phase is operatively connected to the at least one reference voltage. For example, as shown in Figure 1, during the first voltage measurement phase, the first analog to digital converter is connected to the first battery cell 102, and the final analog to digital converter 120 is operatively connected to the second reference voltage 156. Likewise, as shown in Figure 2, during the second voltage measurement phase, the first analog to digital converter 120 is operatively connected to the first reference voltage 154, and the final analog to digital converter 120 is operatively connected to the final battery cell 110.

Each analog to digital converter is configured to measure the voltage of the device to which it is operatively connected during any given voltage measurement phase, whether that device is a battery cell or a reference voltage, and to transmit each measured voltage to a controller 158. Thus, each analog to digital converter transmits a first phase voltage measurement and a second phase voltage measurement to the controller. In the example shown in Figures 1 and 2, each analog to digital converter may transmit a first phase voltage measurement to the controller during or at the conclusion of the first voltage measurement phase, and transmits a second phase voltage measurement to the controller during or at the conclusion of the second voltage measurement phase.

For example, referring to Figure 1, during the first voltage measurement phase, the first analog to digital converter 112 measures the voltage of the first battery cell 102 and then transmit a first phase voltage measurement 160 of the first battery cell to the controller 158. Correspondingly, the second, third, and fifth analog to digital converters 114, 116, and 118 respectively measure the respective voltages of the second, third, and fifth battery cells 104, 106, and 110, respectively, and then transmit respective first phase voltage measurements 162, 164, and 166 of the second, third, and fifth battery cells, respectively, to the controller 158. The final analog to digital converter 120 measures the voltage of the second reference voltage 156, and then transmits a first phase voltage measurement 168 of the second reference voltage to the controller 158.

Further, referring to Figure 2, during the second voltage measurement phase, the first analog to digital converter 112 measures the voltage of the first reference voltage 154, and then transmit a second phase voltage measurement 170 of the first reference voltage 154 to the controller 158. Further, the second, third, and fifth analog to digital converters 114, 116, and 118, respectively, measure the respective voltages of the first, second, and fourth battery cells 102, 104, and 108, respectively, and then transmit respective second phase voltage measurements 172, 174, and 176 of the first, second, and fourth battery cells, respectively, to the controller 158. The final analog to digital converter 120 measures the voltage of the fifth battery cell 110 and then transmits a second phase voltage measurement 178 of the fifth battery cell to the controller 158.

It should be understood that the analog to digital converters may be configured to transmit the first phase voltage measurements and second phase voltage measurements at any suitable time during or at the conclusion of a voltage measurement phase. The first phase voltage measurements and the second phase voltage measurements may be transmitted either in sequence or simultaneously, or substantially simultaneously, such as transmitting both at the conclusion of the second voltage measurement phase.

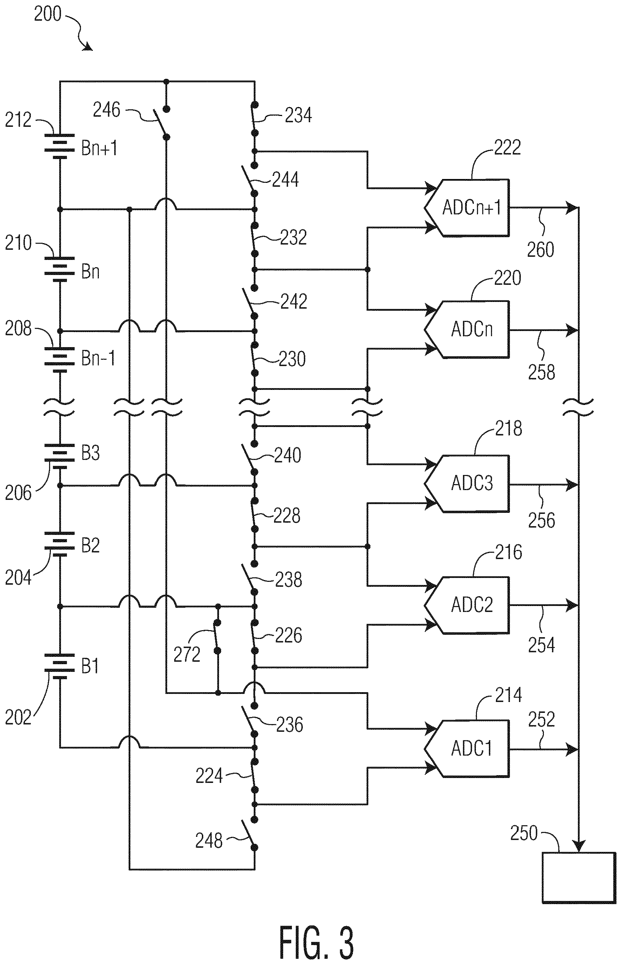

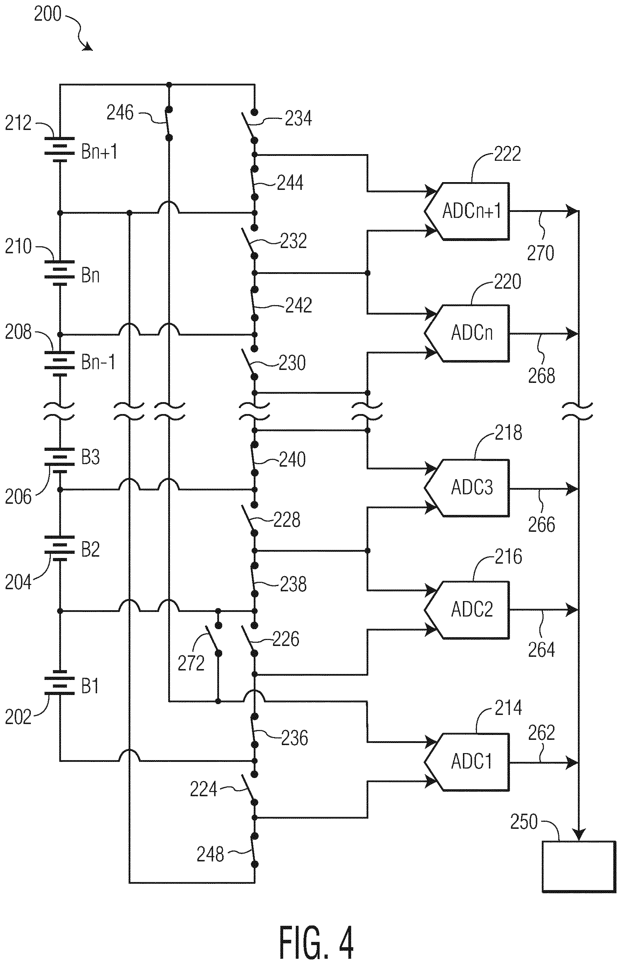

Figures 3 and 4 illustrate an alternative configuration for a fault tolerant battery cell voltage measurement system of the present technology in which the plurality of battery cells may be operatively connected to the plurality of analog to digital converters in a 1:1 ratio of battery cells to digital to analog converters during each voltage measurement phase. The fault tolerant battery cell voltage measurement system 200 shown in Figures 3 and 4, like the fault tolerant battery cell voltage measurement system 100, provides redundant monitoring of each battery cell within the system. The fault tolerant battery cell voltage measurement system 200 has many similarities with respect to its configuration and operation as compared to the fault tolerant battery cell voltage measurement system 100. However, the fault tolerant battery cell voltage measurement system 200 differs from the fault tolerant battery cell voltage measurement system 100 in that the number of analog to digital converters in the plurality of analog to digital converters may be equal to the number of battery cells in the plurality of battery cells, and the fault tolerant battery cell voltage measurement system 200 as shown does not include any reference voltages.

As shown in Figures 3 and 4, the fault tolerant battery cell voltage measurement system 200 is installed for use with a plurality of battery cells. The plurality of battery cells may include any suitable number of battery cells, depending upon the embodiment. Conceptually, each battery cell of the plurality of battery cells may be identified in sequence from a first battery cell B₁, second battery cell B₂, and so forth, through battery cell Bₙ₊₁. The fault tolerant battery cell voltage measurement system 200 includes at least a first battery cell 202 and a second battery cell 204. In the example of Figures 3 and 4, at least six battery cells are shown, including a first battery cell 202, a second battery cell 204, a third battery cell 206, a fourth battery cell 208, a fifth battery cell 210, and a sixth or final battery cell 212.

The fault tolerant battery cell voltage measurement system 200 includes a plurality of analog to digital converters. The number of analog to digital converters in the plurality of analog to digital converters is dependent on the number of battery cells in the plurality of battery cells, and in this example is equal to the number of battery cells in the plurality of battery cells. Conceptually, in this example, each analog to digital converter of the plurality of analog to digital converters may be identified in sequence from a first analog to digital converter ADC₁,second analog to digital converter ADC₂, and so forth, through analog to digital converter ADCₙ₊₁.The fault tolerant battery cell voltage measurement system 200 includes at least a first analog to digital converter 214, a second analog to digital converter 216, and a third analog to digital converter 218. In the example of Figures 3 and 4, the plurality of analog to digital converters includes a first analog to digital converter 214, a second analog to digital converter 216, a third analog to digital converter 218, a fourth analog to digital converter (not shown), a fifth analog to digital converter 220, and a sixth or final analog to digital converter 222. As shown, conceptually, the fourth analog to digital converter (not shown) would correspond to analog to digital converter ADCₙ₋₁.

The fault tolerant battery cell voltage measurement system 200 uses at least two voltage measurement phases to provide voltage monitoring redundancy. Each analog to digital converter is configured to measure the voltage of the battery cell to which it is operatively connected during each voltage measurement phase. For example, each battery cell may be operatively connected to one analog to digital converter during a first voltage measurement phase, and the analog to digital converter to which each battery cell is operatively connected may measure the voltage of that battery cell during the first voltage measurement phase. Similarly, each battery cell may be operatively connected to a different analog to digital converter during a second voltage measurement phase, and the different analog to digital converter to which each battery cell is operatively connected may measure the voltage of that battery cell during the second voltage measurement phase.

In order to operatively connect each battery cell to one analog to digital converter during the first voltage measurement phase, and to a different analog to digital converter during the second voltage measurement phase, at least two sets of switches are provided. For example, as shown in Figures 3 and 4, a first set of switches operatively connects each battery cell to one analog to digital converter during the first voltage measurement phase, and a second set of switches operatively connects each battery cell to a different analog to digital converter during the second voltage measurement phase. In the present embodiment, the first set of switches includes switches 224, 226, 228, 230, 232, 234, and 272 and the second set of switches includes switches 236, 238, 240, 242, 244, 246 and 248. Other arrangements of switches may be used to provide the first set of switches and second set of switches.

During the first voltage measurement phase, as shown in Figure 3, the first set of switches, such as switches 224, 226, 228, 230, 232, 234, and 272, is closed by the controller to connect each battery cell to an analog to digital converter, such that each battery cell is operatively connected to a separate analog to digital converter. The second set of switches, such as 236, 238, 240, 242, 244, 246 and 248, is open during the first voltage measurement phase. The first set of switches may operatively connect each battery cell to an analog to digital converter in a first pattern. For example, conceptually, the battery cell B₁ may be operatively connected to the analog to digital converter ADC₁, the battery cell B2 may be operatively connected to the analog to digital converter ADC2, and so forth, with the battery cell Bₙ being operatively connected to the analog to digital converter ADCₙ, and the battery cell Bₙ₊₁ being operatively connected to the analog to digital converter ADCₙ₊₁.Thus, with reference to Figure 3, during the first voltage measurement phase, the first battery cell 202 is operatively connected to the first analog to digital converter 214 by at least first switch 224 of the first set of switches, and the second battery cell 204 is operatively connected to the second analog to digital converter 216 by at least a second switch 226 of the first set of switches. Similarly, the final battery cell 212 is operatively connected to the final analog to digital converter 222 by at least a final switch 234 of the first set of switches.

During the second voltage measurement phase, as shown in Figure 4, the second set of switches, such as switches 236, 238, 240, 242, 244, 246 and 248, is closed by the controller to connect each battery cell to a different analog to digital converter, such that each battery cell is operatively connected to a separate analog to digital converter that is different from the analog to digital converter to which the battery cell was connected during the first voltage measurement phase. The first set of switches, such as switches 224, 226, 228, 230, 232, 234, and 272, is open during the second voltage measurement phase. The second set of switches may operatively connect each battery cell to an analog to digital converter in a second pattern. For example, conceptually, the battery cell B₁ may be operatively connected to the analog to digital converter ADC₂, the battery cell B₂ may be operatively connected to the analog to digital converter ADC₃, and so forth, with the battery cell Bₙ being operatively connected to the analog to digital converter ADCₙ₊₁. In such an example, the first analog to digital converter ADC₁ may be operatively connected to the final battery cell Bₙ₊₁. Thus, with reference to Figure 4, during the second voltage measurement phase, the first battery cell 202 is operatively connected to the second analog to digital converter 216 by at least first switch 236 of the second set of switches, and the second battery cell 204 is operatively connected to the third analog to digital converter 218 by at least a second switch 238 of the second set of switches. And the final battery cell 212 is operatively connected to the first analog to digital converter 214 by at least a final switch 248 of the second set of switches.

Each analog to digital converter fault tolerant battery cell voltage measurement system 200 is configured to measure the voltage of the battery cell to which it is operatively connected during any given voltage measurement phase, and to transmit each measured voltage to a controller 250. Thus, each analog to digital converter may transmit a first phase voltage measurement and a second phase voltage measurement to the controller 250. In the example shown in Figures 3 and 4, each analog to digital converter transmits a first phase voltage measurement to the controller 250 during or at the conclusion of the first voltage measurement phase, and transmits a second phase voltage measurement to the controller 250 during or at the conclusion of the second voltage measurement phase.

For example, referring to Figure 3, during the first voltage measurement phase, the first analog to digital converter 214 measures the voltage of the first battery cell 202 and then transmits a first phase voltage measurement 252 of the first battery cell to the controller 250. The second analog to digital converter 216 measures the voltage of the second battery cell 204 and then transmits a first phase voltage measurement 254 of the second battery cell to the controller 250. The third, fifth and final analog to digital converters 218, 220, and 222, respectively, measure the voltage of the third, fifth, and final battery cells 206, 210, and 212, respectively, and then transmit a first phase voltage measurement 256 of the third battery cell, a first phase voltage measurement 258 of the fifth battery cell, and a first phase voltage measurement 260 of the final battery cell, respectively, to the controller 250.

Further, referring to Figure 4, during the second voltage measurement phase, the first analog to digital converter 214 measures the voltage of the final battery cell 212, and transmits a second phase voltage measurement 262 of the final battery cell to the controller 250. The second analog to digital converter 216 measures the voltage of the first battery cell 202 and transmits a second phase voltage measurement 264 of the first battery cell to the controller 250. The third, fifth and final analog to digital converters 218, 220, and 222, respectively, measure the voltage of the second, fourth, and fifth battery cells 204, 208, and 210, respectively, and transmit a second phase voltage measurement 266 of the second battery cell, a second phase voltage measurement 268 of the fourth battery cell, and a second phase voltage measurement 270 of the fifth battery cell, respectively, to the controller 250.

Similarly to the fault tolerant battery cell voltage measurement system 100, it should be understood that the analog to digital converters of the fault tolerant battery cell voltage measurement system 200 may be configured to transmit the first phase voltage measurements and second phase voltage measurements at any suitable time during or at the conclusion of a voltage measurement phase. The first phase voltage measurements and the second phase voltage measurements may be transmitted either in sequence or simultaneously, or substantially simultaneously, such as transmitting both at the conclusion of the second voltage measurement phase.

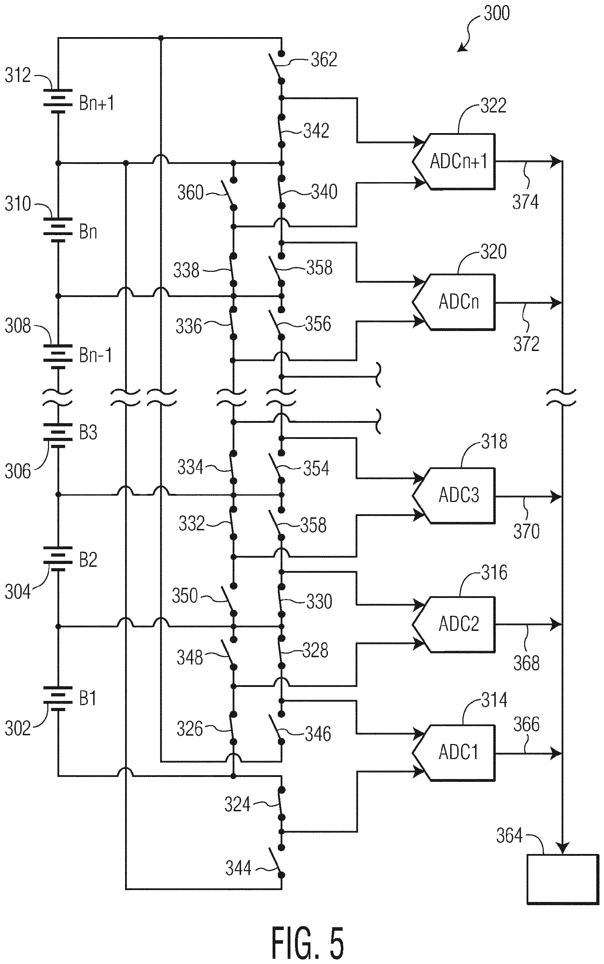

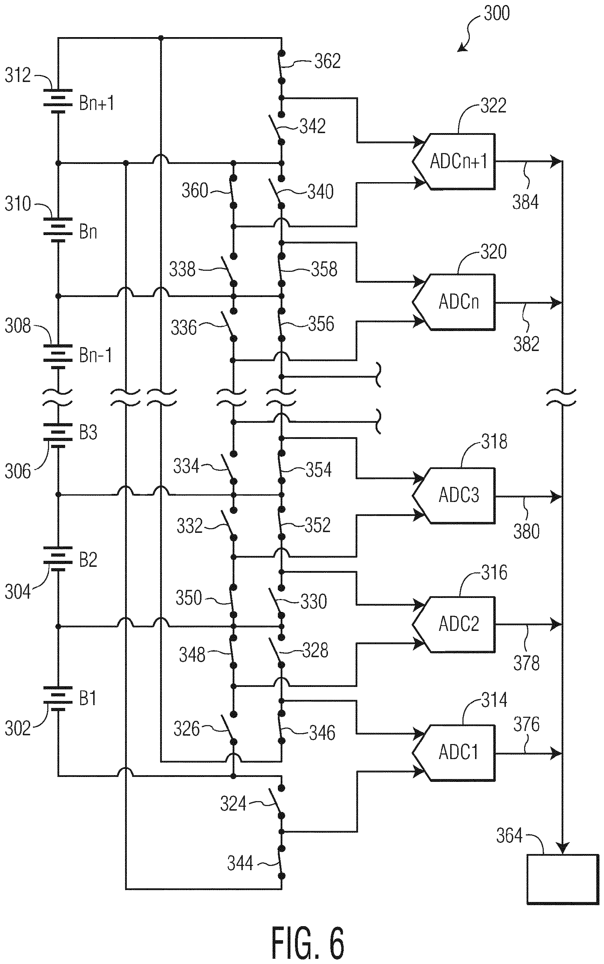

Figures 5 and 6 illustrate another alternative example of a fault tolerant battery cell voltage measurement system 300 of the present technology. Figure 5 shows the fault tolerant battery cell voltage measurement system 300 during a first voltage measurement phase, and Figure 6 shows the fault tolerant battery cell voltage measurement system 300 during a second voltage measurement phase. The example of fault tolerant battery cell voltage measurement system 300 shown in Figures 5 and 6 has many similarities to the examples of fault tolerant battery cell voltage measurement system 100 shown in Figures 1 and 2 and fault tolerant battery cell voltage measurement system 200 shown in Figures 3 and 4, but differs in that a subset of the plurality of battery cells is operatively connected to a subset of the plurality of analog to digital converters in a 1:2 ratio of battery cells to analog to digital converters during each voltage measurement phase.

Referring to Figures 5 and 6, the fault tolerant battery cell voltage measurement system 300 is shown as installed for use with a plurality of battery cells. The plurality of battery cells may include any suitable number of battery cells, depending upon the embodiment. Conceptually each battery cell of the plurality of battery cells may be identified in sequence from a first battery cell B₁, second battery cell B₂, and so forth, through battery cell Bₙ₊₁. In at least some examples, the fault tolerant battery cell voltage measurement system 300 includes at least a first battery cell 302 and a second battery cell 304. In the example of Figures 5 and 6, the plurality of battery cells includes at least first battery cell 302, second battery cell 304, third battery cell 306, fourth battery cell 308, fifth battery cell 310, and sixth or final battery cell 312.

The fault tolerant battery cell voltage measurement system 300 also includes a plurality of analog to digital converters. The number of analog to digital converters in the plurality of analog to digital converters is dependent on the number of battery cells in the plurality of battery cells, and may be equal to or greater than the number of battery cells in the plurality of battery cells. In the example shown in Figures 5 and 6, the number of analog to digital converters in the plurality of analog to digital converters is equal to the number of battery cells in the plurality of battery cells. Conceptually, in such an example, each analog to digital converter of the plurality of analog to digital converters may be identified in sequence from a first analog to digital converter ADC₁, second analog to digital converter ADC₂, and so forth, through analog to digital converter ADCₙ₊₁. In at least some examples, the fault tolerant battery cell voltage measurement system 300 includes at least a first analog to digital converter 314, a second analog to digital converter 316, and a third analog to digital converter 318. In the example illustrated in Figures 5 and 6, the plurality of analog to digital converters includes a first analog to digital converter 314, a second analog to digital converter 316, a third analog to digital converter 318, fourth analog to digital converter (not shown), a fifth analog to digital converter 320, and a sixth or final analog to digital converter 322. As shown, conceptually, the fourth analog to digital converter (not shown) would correspond to analog to digital converter ADCₙ₋₁.

The fault tolerant battery cell voltage measurement system 300 may use at least two voltage measurement phases to provide voltage monitoring redundancy. Each analog to digital converter is configured to measure the voltage of the battery cell to which it is operatively connected during each voltage measurement phase. In at least one example, the plurality of battery cells may be operatively connected to the plurality of analog to digital converters in a 1:2 ratio during each voltage measurement phase.

In order to operatively connect each battery cell to two analog to digital converters during at least one of the first voltage measurement phase or the second voltage measurement phase, at least two sets of switches are be provided. For example, a first set of switches may operatively connect each battery cell of a first subset of the plurality of battery cells to two analog to digital converters during the first voltage measurement phase, and a second set of switches may operatively connect each battery cell of a second subset of the plurality of battery cells to two analog to digital converters during the second voltage measurement phase. As shown in Figures 5 and 6, the first set of switches includes switches 324, 326, 328, 330, 332, 334, 336, 338, 340, and 342, and the second set of switches includes switches 344, 346, 348, 350, 352, 354, 356, 358, 360, and 362. Other arrangements of switches may be used to provide the first set of switches and second set of switches. In the example shown in Figures 5 and 6, the first set of switches, such as switches 324, 326, 328, 330, 332, 334, 336, 338, 340, and 342, and the second set of switches, such as switches 344, 346, 348, 350, 352, 354, 356, 358, 360, and 362, may each operatively connect the plurality of battery cells to the plurality of analog to digital converters in a 1:2 ratio of battery cells to analog to digital converters.

As shown in Figure 5, during the first voltage measurement phase, the first set of switches operatively connects a first subset of battery cells to a first subset of analog to digital converters, and each battery cell of the first subset of battery cells is operatively connected to two of the analog to digital converters. In this example, the first subset of battery cells includes a first half of the battery cells, and the first subset of analog to digital converters includes all of the analog to digital converters. The operative connection may be formed by the controller closing each switch of the first set of switches, and opening each switch of the second set of switches.

For example, conceptually, half of the battery cells, such as every other battery cell or every odd numbered battery cell, may be operatively connected to two analog to digital converters. The battery cell B₁ may be operatively connected to the analog to digital converter ADC₁ and the analog to digital converter ADC₂. The battery cell B₂ may be not connected to an analog to digital converter. The battery cell B₃ may be operatively connected to the analog to digital converter ADC₃ and the analog to digital converter ADC₄. The pattern may continue, with the battery cell Bₙ being operatively connected to the analog to digital converter ADCₙ and the analog to digital converter ADCₙ₊₁. Such an arrangement is shown in Figure 5, in which, during the first voltage measurement phase, the first battery cell 302 is operatively connected to the first analog to digital converter 314 by at least a first switch 324 of the first set of switches, and operatively connected to the second analog to digital converter 316 by at least a second switch 326 of the first set of switches..

Similarly, as shown in Figure 6, during the second voltage measurement phase, the second set of switches operatively connects a second subset of battery cells to a second subset of analog to digital converters, and each battery cell of the second subset of battery cells is operatively connected to two of the analog to digital converters. In this example, the second subset of battery cells includes a second half of the battery cells, and the second subset of analog to digital converters may include all of the analog to digital converters. The operative connection may be formed in at least some examples by the controller closing each switch of the second set of switches, and opening each switch of the first set of switches.

For example, conceptually, the other half of the battery cells, such as every other battery cell or every even numbered battery cell, may be operatively connected to two analog to digital converters. The battery cell B₂ may be operatively connected to the analog to digital converter ADC₂ and the analog to digital converter ADC₃. The battery cells B₁ and B₃ may be not connected to an analog to digital converter. The battery cell Bₙ₋₁ may be operatively connected to the analog to digital converter ADCₙ₋₁ (not shown) and the analog to digital converter ADCₙ. The pattern may continue, with the battery cell Bₙ₊₁ being operatively connected to the analog to digital converter ADCₙ₊₁ and the analog to digital converter ADC₁. Such an arrangement is shown in Figure 6, in which, during the second voltage measurement phase, the second battery cell 304 is operatively connected to the second analog to digital converter 316 by at least a first switch 348 of the second set of switches, and operatively connected to the third analog to digital converter 318 by at least a second switch 350 of the first set of switches..

Each analog to digital converter is configured to measure the voltage of the battery cell to which it is operatively connected during any given voltage measurement phase, and to transmit each measured voltage to a controller 364. Thus, each analog to digital converter may transmit a first phase voltage measurement and a second phase voltage measurement to the controller. In the example shown in Figures 5 and 6, each analog to digital converter transmits a first phase voltage measurement to the controller 364 during or at the conclusion of the first voltage measurement phase, and transmits a second phase voltage measurement to the controller 364 during or at the conclusion of the second voltage measurement phase.

For example, referring to Figure 5, during the first voltage measurement phase, the first analog to digital converter 314 measures the voltage of the first battery cell 302 and then transmits a first phase voltage measurement 366 of the first battery cell to the controller 364. The second analog to digital converter 316 also measures the voltage of the first battery cell 302 and then transmits another first phase voltage measurement 368 of the first battery cell to the controller 364. The third analog to digital converter 318 and fourth analog to digital converter (not shown) each measure the voltage of the third battery cell 306 and then transmit a first phase voltage measurement 370 and another first phase voltage measurement (not shown), respectively, of the third battery cell to the controller 364. The fifth and final analog to digital converters 320 and 322, respectively, measure the voltage of the fifth battery cell 310 and then transmit first phase voltage measurements 372 and 374, respectively, of the fifth battery cell to the controller 364.

Further, referring to Figure 6, during the second voltage measurement phase, the first analog to digital converter 314 measures the voltage of the sixth battery cell 312 and then transmits a second phase voltage measurement 376 of the sixth battery cell to the controller 364. The sixth analog to digital converter 322 also measures the voltage of the sixth battery cell 312 and then transmits another second phase voltage measurement 384 of the sixth battery cell to the controller 364. The second analog to digital converter 316 measures the voltage of the second battery cell 304 and then transmits a second phase voltage measurement 378 of the second battery cell to the controller 364. The third analog to digital converter also measures the voltage of the second battery cell 304 and then transmits another second phase voltage measurement 380 of the third battery cell to the controller 364.

As with the fault tolerant battery cell voltage measurement systems 100 and 200, it should be understood that the analog to digital converters of fault tolerant battery cell voltage measurement system 300 may be configured to transmit the first phase voltage measurements and second phase voltage measurements at any suitable time during or at the conclusion of a voltage measurement phase. The first phase voltage measurements and the second phase voltage measurements may be transmitted either in sequence or simultaneously, or substantially simultaneously, such as transmitting both at the conclusion of the second voltage measurement phase.

Controllers of the present technology, including controller 158 shown in Figures 1 and 2, and controller 250 shown in Figures 3 and 4, and controller 364 shown in Figures 5 and 6 are configured to control opening and closing of each set of switches to initiate each voltage measurement phase, including at least a first voltage measurement phase and a second voltage measurement phase. For example, with reference to Figures 1 and 2, controller 158 may close the first set of switches, such as switches 122, 124, 126, 128, 130, 132, 134, and 136, and open the second set of switches, such as switches 138, 140, 142, 144, 146, 148, 150, and 152, to initiate a first phase voltage measurement. Additionally, controller 158 may open the first set of switches, such as switches 122, 124, 126, 128, 130, 132, 134, and 136, and close the second set of switches, such as switches 138, 140, 142, 144, 146, 148, 150, and 152, to initiate a second phase voltage measurement. Similarly, with reference to Figures 3 and 4, controller 250 may close the first set of switches, such as switches 224, 226, 228, 230, 232, 234, and 272, and open the second set of switches, such as switches 236, 238, 240, 242, 244, 246 and 248, to initiate a first phase voltage measurement. Additionally, controller 250 may open the first set of switches, such as switches 224, 226, 228, 230, 232, 234, and 272, and close the second set of switches, such as switches 236, 238, 240, 242, 244, 246 and 248, to initiate a second phase voltage measurement. Further, with reference to Figures 5 and 6, controller 364 may close the first set of switches, such as switches 324, 326, 328, 330, 332, 334, 336, 338, 340, and 342, and open the second set of switches, such as switches 344, 346, 348, 350, 352, 354, 356, 358, 360, and 362 to initiate a first phase voltage measurement. Additionally, controller 364 may open the first set of switches, such as switches 324, 326, 328, 330, 332, 334, 336, 338, 340, and 342, and close the second set of switches, such as switches 344, 346, 348, 350, 352, 354, 356, 358, 360, and 362 to initiate a second phase voltage measurement.

Controllers of the present technology, such as controllers 158, 250, and 364, are also configured to each receive input data that includes the first phase voltage measurement from each analog to digital converter and the second phase voltage measurement from each analog to digital converter. Controllers of the present technology, including controllers 158, 250, and 364, may also be configured to analyze the input data to generate analyzed data, and determine whether one of the plurality of analog to digital converters is faulty based on the analyzed data. Controllers 158, 250, and 364 may each include at least one processor, and at least one memory. The at least one memory may include at least one non-volatile memory that stores one or more software programs that, when read and executed by the at least one processor cause the controller 158, 250, or 364 to perform the controller functions described herein.

Referring to Figures 1 and 2, the controller 158 receives input data that includes the first phase voltage measurement from each analog to digital converter and the second phase voltage measurement from each analog to digital converter. With reference to Figure 1, the first phase voltage measurement from each analog to digital converter includes the first phase voltage measurement 160 of the first battery cell transmitted from the first analog to digital converter 112, the first phase voltage measurement 162 of the second battery cell transmitted from the second analog to digital converter 114, the first phase voltage measurement 164 of the third battery cell transmitted from the third analog to digital converter 116, the first phase voltage measurement 166 of the fifth battery cell transmitted from the fifth analog to digital converter 118, and the first phase voltage measurement 168 of the second reference voltage transmitted from the final analog to digital converter 120. With reference to Figure 2, the second phase voltage measurement from each analog to digital converter includes the second phase voltage measurement 170 of the of the second reference voltage 154 transmitted by the first analog to digital converter 112, the second phase voltage measurement 172 of the first battery cell 102 transmitted by the second analog to digital converter 114, the second phase voltage measurement 174 of the second battery cell transmitted by the third analog to digital converter 116, the second phase voltage measurement 176 of the fourth battery cell transmitted by the fifth analog to digital converter 118, and the second phase voltage measurement 178 of the fifth battery cell transmitted from the final analog to digital converter 120.

Referring to Figures 3 and 4, the controller 250 receives input data that includes the first phase voltage measurement from each analog to digital converter and the second phase voltage measurement from each analog to digital converter. With reference to Figure 3, the first phase voltage measurement from each analog to digital converter includes the first phase voltage measurement 252 of the first battery cell 202 transmitted from the first analog to digital converter 214, the first phase voltage measurement 254 of the second battery cell 204 transmitted from the second analog to digital converter 216, the first phase voltage measurement 256 of the third battery cell 206 transmitted from the third analog to digital converter 218, the first phase voltage measurement 258 of the fifth battery cell 210 transmitted from the fifth analog to digital converter 220, and the first phase voltage measurement 260 of the final battery cell 212 transmitted from the final analog to digital converter 222. With reference to Figure 4, the second phase voltage measurement from each analog to digital converter includes the second phase voltage measurement 262 of the of the final battery cell 212 transmitted by the first analog to digital converter 214, the second phase voltage measurement 264 of the first battery cell 202 transmitted by the second analog to digital converter 216, the second phase voltage measurement 266 of the second battery cell 204 transmitted by the third analog to digital converter 218, the second phase voltage measurement 268 of the fourth battery cell 208 transmitted by the fifth analog to digital converter 220, and the second phase voltage measurement 270 of the fifth battery cell 210 transmitted from the final analog to digital converter 222.

Referring to Figures 5 and 6, the controller 364 receives input data that includes the first phase voltage measurement from each analog to digital converter and the second phase voltage measurement from each analog to digital converter. With reference to Figure 5, the first phase voltage measurement from each analog to digital converter includes the first phase voltage measurement 366 of the first battery cell 302 transmitted from the first analog to digital converter 314, the first phase voltage measurement 368 of the first battery cell 304 transmitted from the second analog to digital converter 316, the first phase voltage measurement 370 of the third battery cell 306 transmitted from the third analog to digital converter 318, the first phase voltage measurement 372 of the fifth battery cell 310 transmitted from the fifth analog to digital converter 320, and the first phase voltage measurement 374 of the fifth battery cell 310 transmitted from the final analog to digital converter 322. With reference to Figure 6, the second phase voltage measurement from each analog to digital converter includes the second phase voltage measurement 376 of the of the final battery cell 312 transmitted by the first analog to digital converter 314, the second phase voltage measurement 378 of the second battery cell 304 transmitted by the second analog to digital converter 316, the second phase voltage measurement 380 of the second battery cell 304 transmitted by the third analog to digital converter 318, the second phase voltage measurement 382 of the fourth battery cell 310 transmitted by the fifth analog to digital converter 320, and the second phase voltage measurement 384 of the final battery cell 312 transmitted from the final analog to digital converter 322.

Each controller 158, 250 and 364 may analyze the input data at least in part by comparing the first voltage measurement of each battery cell to the second voltage measurement of the same battery cell, whenever those measurement are taken within the plurality of voltage measurement phases. In examples such as fault tolerant battery cell voltage measurement system 100 shown in Figures 1 and 2, and fault tolerant battery cell voltage measurement system 200 shown in Figures 3 and 4, the analysis may include comparing a first phase voltage measurement of the first battery cell to a second phase voltage measurement of the first battery cell, and comparing a first phase voltage measurement of the second battery cell to a second phase voltage measurement of the second battery cell. Alternatively, in examples such as fault tolerant battery cell voltage measurement system 300, the analysis may include comparing the first phase voltage measurement of the first battery cell 302 by the first analog to digital converter 314 to the first phase voltage measurement of the first battery 302 cell by the second analog to digital converter 316. Each controller 158, 250 and 364 may determine whether one of the plurality of analog to digital converters in its system is faulty based on the analyzed data.

For example, referring to Figures 1 and 2, controller 158 may compare a first phase voltage measurement 160 of the first battery cell 102 received from the first analog to digital converter 112 to the second phase voltage measurement 172 of the first battery cell 102 received from the second analog to digital converter 114. Controller 158 may then determine whether first phase voltage measurement 160 of the first battery cell 102 received from the first analog to digital converter 112 is equal to the second phase voltage measurement 172 of the first battery cell 102 received from the second analog to digital converter 114. If they are equal, then the controller may determine that the first analog to digital converter 112 and the second analog to digital converter 114 are not faulty. If they are not equal, then the controller may determine that at least one of the first analog to digital converter 112 and the second analog to digital converter 114 is faulty.

In order to determine which analog to digital converter is faulty between the first analog to digital converter 112 and the second analog to digital converter 114, the controller may analyze the other voltage measurements taken by the first analog to digital converter 112 and the second analog to digital converter 114 during the first and second measurement phases. For example, the first analog to digital converter 112 measures the voltage of the first reference voltage 154 during the second voltage measurement phase, and the voltage of the first reference voltage 154 is constant and known. Thus, the controller may compare the second phase voltage measurement 170 of the first reference voltage 154 as measured by the first analog to digital converter 112 to the known voltage value of the first reference voltage 154, and determine whether they are the same. If the second phase voltage measurement 170 of the first reference voltage 154 as measured by the first analog to digital converter 112 is equal to the known voltage value of the first reference voltage 154, the controller 158 may determine that the first analog to digital converter 112 is not faulty. If the second phase voltage measurement 170 of the first reference voltage 154 as measured by the first analog to digital converter 112 is not equal to the known voltage value of the first reference voltage 154, the controller 158 may determine that the first analog to digital converter 112 is faulty. With respect to the second analog to digital converter 114, the controller may compare the first phase voltage measurement 162 of the second battery cell 104 as measured by the second analog to digital converter 114 to the second phase voltage measurement 174 of the second battery cell 104 as measured by the third analog to digital converter 116. If the first phase voltage measurement 162 of the second battery cell 104 as measured by the second analog to digital converter 114 is equal to the second phase voltage measurement 174 of the second battery cell 104 as measured by the third analog to digital converter 116, the controller may determine that the second analog to digital converter 114 is not faulty. If the first phase voltage measurement 162 of the second battery cell 104 as measured by the second analog to digital converter 114 is not equal to the second phase voltage measurement 174 of the second battery cell 104 as measured by the third analog to digital converter 116, the controller may determine that the second analog to digital converter 114 is faulty.

Referring to Figures 3 and 4, controller 250 may compare a first phase voltage measurement 252 of the first battery cell 202 received from the first analog to digital converter 214 to the second phase voltage measurement 264 of the first battery cell 202 received from the second analog to digital converter 216. Controller 250 may then determine whether first phase voltage measurement 252 of the first battery cell 202 received from the first analog to digital converter 214 is equal to the second phase voltage measurement 264 of the first battery cell 202 received from the second analog to digital converter 216. If they are equal, then the controller may determine that the first analog to digital converter 214 and the second analog to digital converter 216 are not faulty. If they are not equal, then the controller may determine that at least one of the first analog to digital converter 214 and the second analog to digital converter 216 is faulty.

In order to determine which analog to digital converter is faulty between the first analog to digital converter 214 and the second analog to digital converter 216, the controller 250 may analyze the other voltage measurements taken by the first analog to digital converter 214 and the second analog to digital converter 216 during the first and second measurement phases. For example, the first analog to digital converter 214 measures the voltage of the final battery cell 212 during the second voltage measurement phase, and the voltage of the final battery cell 212 is also measured by the final analog to digital converter 222 during the first voltage measurement phase. Thus, the controller may compare the second phase voltage measurement 262 of the final battery cell 212 as measured by the first analog to digital converter 214 to the first phase voltage measurement 270 of the final battery cell 212 as measured by the final analog to digital converter 222, and determine whether they are the same. If the second phase voltage measurement 262 of the final battery cell 212 as measured by the first analog to digital converter 214 is equal to the first phase voltage measurement 270 of the final battery cell 212 as measured by the final analog to digital converter 222, the controller 250 may determine that the first analog to digital converter 214 is not faulty. If the second phase voltage measurement 262 of the final battery cell 212 as measured by the first analog to digital converter 214 is not equal to the first phase voltage measurement 270 of the final battery cell 212 as measured by the final analog to digital converter 222, the controller 250 may determine that the first analog to digital converter 214 is faulty.

With respect to the second analog to digital converter 216, the controller 250 may compare the first phase voltage measurement 254 of the second battery cell 204 as measured by the second analog to digital converter 216 to the second phase voltage measurement 266 of the second battery cell 204 as measured by the third analog to digital converter 218. If the first phase voltage measurement 254 of the second battery cell 204 as measured by the second analog to digital converter 216 is equal to the second phase voltage measurement 266 of the second battery cell 204 as measured by the third analog to digital converter 218, the controller may determine that the second analog to digital converter 216 is not faulty. If the first phase voltage measurement 254 of the second battery cell 204 as measured by the second analog to digital converter 216 is not equal to the second phase voltage measurement 266 of the second battery cell 204 as measured by the third analog to digital converter 218, the controller may determine that the second analog to digital converter 216 is faulty.

Referring to Figures 5 and 6, controller 364 may compare a first phase voltage measurement 366 of the first battery cell 302 received from the first analog to digital converter 314 to the first phase voltage measurement 368 of the first battery cell 302 received from the second analog to digital converter 316. Controller 364 may then determine whether the first phase voltage measurement 366 of the first battery cell 302 received from the first analog to digital converter 314 is equal to the first phase voltage measurement 368 of the first battery cell 302 received from the second analog to digital converter 316. If they are equal, then the controller may determine that the first analog to digital converter 314 and the second analog to digital converter 316 are not faulty. If they are not equal, then the controller may determine that at least one of the first analog to digital converter 314 and the second analog to digital converter 316 is faulty.

In order to determine which analog to digital converter is faulty between the first analog to digital converter 314 and the second analog to digital converter 316, the controller 364 may analyze the other voltage measurements taken by the first analog to digital converter 314 and the second analog to digital converter 316 during the second voltage measurement phase.

For example, the first analog to digital converter 314 measures the voltage of the final battery cell 312 during the second voltage measurement phase, and the voltage of the final battery cell 312 is also measured by the final analog to digital converter 322 during the second voltage measurement phase. Thus, the controller may compare the second phase voltage measurement 376 of the final battery cell 312 as measured by the first analog to digital converter 314 to the second phase voltage measurement 384 of the final battery cell 312 as measured by the final analog to digital converter 322, and determine whether they are equal. If the second phase voltage measurement 376 of the final battery cell 312 as measured by the first analog to digital converter 314 is equal to the second phase voltage measurement 384 of the final battery cell 312 as measured by the final analog to digital converter 322, the controller 364 may determine that the first analog to digital converter 314 is not faulty. If the second phase voltage measurement 376 of the final battery cell 312 as measured by the first analog to digital converter 314 is not equal to the second phase voltage measurement 384 of the final battery cell 312 as measured by the final analog to digital converter 322, the controller 364 may determine that the first analog to digital converter 314 is faulty.

With respect to the second analog to digital converter 316, the controller 364 may compare the second phase voltage measurement 378 of the second battery cell 304 as measured by the second analog to digital converter 316 to the second phase voltage measurement 380 of the second battery cell 304 as measured by the third analog to digital converter 318. If the second phase voltage measurement 378 of the second battery cell 304 as measured by the second analog to digital converter 316 is equal to the second phase voltage measurement 380 of the second battery cell 304 as measured by the third analog to digital converter 318, the controller 364 may determine that the second analog to digital converter 316 is not faulty. If the second phase voltage measurement 378 of the second battery cell 304 as measured by the second analog to digital converter 316 is not equal to the second phase voltage measurement 380 of the second battery cell 304 as measured by the third analog to digital converter 318, the controller 364 may determine that the second analog to digital converter 316 is faulty.

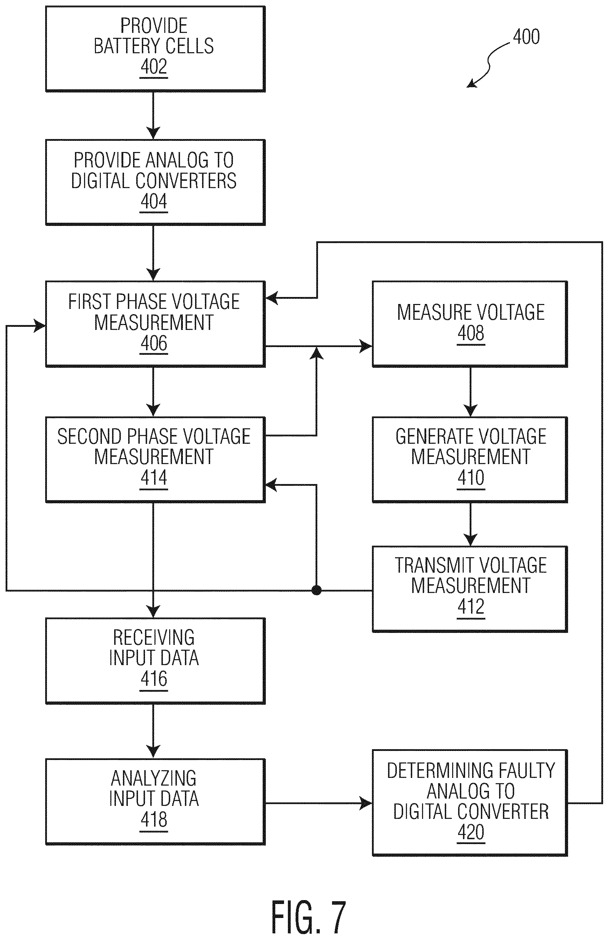

Figure 7 illustrates a flow chart for one method 400 of operating a fault tolerant battery cell voltage measurement system in accordance with the present technology, such as fault tolerant battery cell voltage measurement systems 100 shown in Figures 1 and 2, 200 shown in Figures 3 and 4, and 300 shown in Figures 5 and 6.

Methods of operating a fault tolerant battery cell voltage measurement system for measuring a plurality of voltages of a plurality of battery cells, respectively, may include providing the components of the fault tolerant battery cell voltage measurement system. Accordingly, method 400 may start at step 402, which includes providing a plurality of battery cells. As discussed above, the system may include the battery cells when installed, but alternatively may not include the battery cells, such as prior to installation. Additionally, as discussed with respect to each of fault tolerant battery cell voltage measurement systems 100, 200 and 300, the number of battery cells in the plurality of battery cells may include any number of battery cells depending upon the embodiment, such as at least a first battery cell and a second battery cell. The method 400 may also include step 404, which includes providing a plurality of analog to digital converters. As discussed with respect to each of fault tolerant battery cell voltage measurement systems 100, 200 and 300, the number of analog to digital converters of the plurality of analog to digital converters is based upon the number of battery cells in the plurality of battery cells, but may include at least a first analog to digital converter, a second analog to digital converter, and a final analog to digital converter. It should be understood that steps 402 and 404 may be performed in any order, simultaneously, or substantially simultaneously. The method may further include additional steps (not shown) of providing further components of the system, such as providing a plurality of switches coupled to the plurality of analog to digital converters, where the plurality of switches including a first set of switches and a second set of switches, and providing a controller.

The method may proceed to conducting a plurality of voltage measurement phases, which may include operatively connecting by the controller each battery cell of the plurality of battery cells to two different analog to digital converters within the plurality of voltage measurement phases, such as first voltage measurement phase 406 and second voltage measurement phase 414. For example, method 400 may proceed to step 406, which may include conducting a first phase voltage measurement of a first subset of battery cells using a controller, such as controller 158, 250 or 364, and a first subset of the analog to digital converters. Conducting the first phase voltage measurement may include closing the first set of switches by the controller to operatively connect a first subset of the plurality of battery cells to a first subset of the analog to digital converters during a first voltage measurement phase.

As part of conducting the first phase voltage measurements, the method 400 may proceed through a first loop of steps 408, 410 and 412. For example, step 406 of method 400 may include step 408, which may include measuring a voltage of the first subset of battery cells. In some examples, where the first subset of battery cells includes all of the battery cells and the first subset of battery cells is operatively connected to the first subset of analog to digital converters in a ratio of 1:1 battery cells to analog to digital converters, measuring the voltage of the first subset of battery cells may include measuring the voltage of each battery cell of the first subset of battery cells using the analog to digital converter to which it is operatively connected during the first voltage measurement phase. For example, with respect to fault tolerant battery cell voltage measurement system 100 and fault tolerant battery cell voltage measurement system 200, step 408 may include measuring a voltage of the first battery cell using the first analog to digital converter during the first voltage measurement phase. In other examples, where the first subset of battery cells includes less than all of the battery cells and the first subset of battery cells is operatively connected to the first subset of analog to digital converters in a ratio of 1:2 battery cells to analog to digital converters, measuring the voltage of the first subset of battery cells may include measuring the voltage of each battery cell of the first subset of battery cells using each of the two analog to digital converter to which it is operatively connected during the first voltage measurement phase. For example, with respect to fault tolerant battery cell voltage measurement system 300, step 408 may include measuring a voltage of the first battery cell using the first analog to digital converter and measuring a voltage of the first battery cell using the second analog to digital converter during the first voltage measurement phase.

The method 400 may proceed to step 410, which may include generating a first phase voltage measurement by each analog to digital converter. For example, with respect to fault tolerant battery cell voltage measurement systems 100, 200 and 300, step 410 may include generating a first phase voltage measurement of the first battery cell by the first analog to digital converter. The method 400 may proceed to step 412, which may include transmitting the first phase voltage measurement from each analog to digital converter to the controller. For example, with respect to fault tolerant battery cell voltage measurement systems 100, 200 and 300, step 410 may include transmitting the first phase voltage measurement from the first analog to digital converter to the controller.

Method 400 may proceed to step 414, which includes conducting a second phase voltage measurement of a second subset of the battery cells using the controller, such as controller 158, controller 250, or controller 364, and a second subset of the analog to digital converters. Conducting the second phase voltage measurement may closing the second set of switches by the controller to operatively connect either the first subset or a second subset of the plurality of battery cells to a second subset of the analog to digital converters during a second voltage measurement phase.

As part of conducting the second phase voltage measurement of each battery cell, the method 400 may proceed through a second loop of steps 408, 410 and 412. For example, step 406 of method 400 may include step 408, which may include measuring a voltage of the second subset of battery cells. In some examples, where the second subset of battery cells includes all of the battery cells and the second subset of battery cells is operatively connected to the second subset of analog to digital converters in a ratio of 1: 1 battery cells to analog to digital converters, measuring the voltage of the second subset of battery cells may include measuring the voltage of each battery cell of the second subset of battery cells using the analog to digital converter to which it is operatively connected during the second voltage measurement phase. For example, with respect to fault tolerant battery cell voltage measurement system 100 and fault tolerant battery cell voltage measurement system 200, step 408 may include measuring a voltage of the first battery cell using the second analog to digital converter during the second voltage measurement phase. In other examples, where the second subset of battery cells includes less than all of the battery cells and the second subset of battery cells is operatively connected to the second subset of analog to digital converters in a ratio of 1:2 battery cells to analog to digital converters, measuring the voltage of the second subset of battery cells may include measuring the voltage of each battery cell of the second subset of battery cells using each of the two analog to digital converters to which it is operatively connected during the second voltage measurement phase. For example, with respect to fault tolerant battery cell voltage measurement system 300, step 408 may include measuring a voltage of the second battery cell using the second analog to digital converter and measuring a voltage of the second battery cell using the third analog to digital converter during the second voltage measurement phase.

During conducting of the first and second phase voltage measurements, each of the battery cells of the plurality of battery cells may be s operatively connected to a respective first one of the plurality of analog to digital converters and a respective second one of the plurality of analog to digital converters, either successively during the first and second voltage measurement phases, respectively, or simultaneously during either of the first and second voltage measurement phases. Additionally, at least one of the plurality of analog to digital converters may be coupled to the first battery cell during the first voltage measurement phase and the second battery cell during the second voltage measurement phase.

The method 400 may proceed to step 410, which may include generating a second phase voltage measurement by each analog to digital converter. For example, with respect to fault tolerant battery cell voltage measurement system 100 and fault tolerant battery cell voltage measurement system 200, step 410 may include generating a second phase voltage measurement of the first battery cell by the second analog to digital converter. In another example, such as with respect to fault tolerant battery cell voltage measurement system 300, step 410 may include generating a second phase voltage measurement of the second battery cell by the second analog to digital converter, and generating a second phase voltage measurement of the second battery cell by the third analog to digital converter.

The method 400 may proceed to step 412, which may include transmitting the first phase voltage measurement from each analog to digital converter to the controller. For example, with respect to fault tolerant battery cell voltage measurement systems 100, 200 and 300, step 410 may include transmitting the second phase voltage measurement from the second analog to digital converter to the controller.

In accordance with the description above, the execution of steps 406 and 414 may include transmitting a first phase voltage measurement from each analog to digital converter to a controller, such as during execution of step 412 during the first voltage measurement phase of step 406, as well as transmitting a second phase voltage measurement from each analog to digital converter to the controller, such as during execution of step 412 during the second voltage measurement phase of step 414.

The method 400 may proceed to step 416, which may include receiving input data by the controller. The input data may include the first phase voltage measurement from each analog to digital converter and the second phase voltage measurement from each analog to digital converter. For example, with respect to fault tolerant battery cell voltage measurement systems 100 and 200, the controller receiving the input data may include the controller receiving the first phase voltage measurement of the first battery cell from the first analog to digital converter and the second phase voltage measurement of the first battery cell from the second analog to digital converter. In another example, with respect to fault tolerant battery cell voltage measurement system 300, the controller receiving the input data may include the controller receiving a first phase voltage measurement of the first battery cell from the first analog to digital converter and the second analog to digital converter, and the second phase voltage measurement of the second battery cell from the second analog to digital converter and the third analog to digital converter.

The method 400 may proceed to step 418, which may include analyzing the input data by the controller to generate analyzed data. The analysis conducted by the controller may be in accordance with the analysis described above with reference to fault tolerant battery cell voltage measurement systems 100, 200 and 300. For example, with respect to fault tolerant battery cell voltage measurement systems 100 and 200, analyzing the input data may include comparing a first phase voltage measurement of the first battery cell to a second phase voltage measurement of the first battery cell, and comparing a first phase voltage measurement of the second battery cell to a second phase voltage measurement of the second battery cell. Additionally, analyzing the input data may include comparing a second phase voltage measurement of a first reference voltage to a known voltage value of the first reference voltage, and/or comparing a first phase voltage measurement of a second reference voltage to a known voltage value of the second reference voltage. Further, analyzing the input data may also include determining by the controller whether the first phase voltage measurement of the first battery cell received from the first analog to digital converter is equal to the second phase voltage measurement of the first battery cell received from the second analog to digital converter. As another example, with respect to fault tolerant battery cell voltage measurement system 300, analyzing the input data may include comparing the first phase voltage measurement of the first battery cell from the first analog to digital converter to the first phase voltage measurement of the first battery cell from the second analog to digital converter. Additionally, analyzing the input data may include comparing the second phase voltage measurement of the second battery cell from the second analog to digital converter to the second phase voltage measurement of the second battery cell from the third analog to digital converter. Further, analyzing the input data may also include determining by the controller whether the first phase voltage measurement of the first battery cell received from the first analog to digital converter is equal to the first phase voltage measurement of the first battery cell received from the second analog to digital converter.

The method may proceed to step 420, which may include determining by the controller whether one of the plurality of analog to digital converters is faulty based on the analyzed data. Determination by the controller of whether one of the plurality of analog to digital converters is faulty may be in accordance with the determinations described above with reference to fault tolerant battery cell voltage measurement systems 100, 200, and, based upon whether the various compared redundant measurements are equal or not.

The method 400 may cyclically repeat the sequence of conducting the first voltage measurement phase 406 and the second voltage measurement phase 414, which may allow for continuous monitoring of the voltage of each of the battery cells.

Notwithstanding the above description, the present disclosure is intended to encompass numerous embodiments including those disclosed herein as well as a variety of alternate embodiments. In one example of such an alternate embodiment each battery cell may be connected to a separate analog to digital converter in a non-sequential pattern during the first voltage measurement phase and/or the second voltage measurement phase. Additionally, suitable numbers of reference voltages and analog to digital converters may be used, so long as the voltage of each battery cell is measured by one analog to digital converter during the first voltage measurement phase and a different analog to digital converter during the second voltage measurement phase.

Further, in accordance with at least some examples encompassed herein, the present disclosure relates to fault tolerant battery cell voltage measurement systems and methods of operating fault tolerant battery cell voltage measurement systems.

In at least one aspect, a fault tolerant battery cell voltage measurement system is provided for measuring a plurality of voltages of a plurality of battery cells, respectively, the plurality of battery cells including at least a first battery cell and a second battery cell. The system includes a plurality of analog to digital converters. The system may also include the battery cells. In one example, the number of analog to digital converters in the plurality of analog to digital converters is equal to the number of battery cells in the plurality of battery cells. In another example, the number of analog to digital converters in the plurality of analog to digital converters is equal to the number of battery cells in the plurality of battery cells plus one.

The fault tolerant battery cell voltage measurement system also includes a plurality of switches coupled to the plurality of analog to digital converters. The plurality of switches may include a first set of switches and a second set of switches.

The fault tolerant battery cell voltage measurement system furthers include a controller. The controller is configured to close the first set of switches to operatively connect a first subset of the plurality of battery cells to a first subset of the analog to digital converters during a first voltage measurement phase, and to close the second set of switches to operatively connect either the first subset or a second subset of the plurality of battery cells to a second subset of the analog to digital converters during a second voltage measurement phase. Additionally, each of the battery cells of the plurality of battery cells is operatively connected to a respective first one of the plurality of analog to digital converters and a respective second one of the plurality of analog to digital converters, either successively during the first and second voltage measurement phases, respectively, or simultaneously during either of the first and second voltage measurement phases. Further, at least one of the plurality of analog to digital converters is coupled to the first battery cell during the first voltage measurement phase and the second battery cell during the second voltage measurement phase.

In one example, the controller may be is configured to operatively connect, using at least a first switch of the first set of switches, the first battery cell to a least the first analog to digital converter during the first voltage measurement phase, and operatively connect, using at least a first switch of the second set of switches, the first battery cell to at least the second analog to digital converter during the second voltage measurement phase.

The fault tolerant battery cell voltage measurement system may also include at least one reference voltage. For example, the fault tolerant battery cell voltage measurement system may include a first reference voltage, wherein the first analog to digital converter is operatively connected to the first reference voltage during the second measurement phase. Additionally, the fault tolerant battery cell voltage measurement system may further include a second reference voltage, wherein the final analog to digital converter is operatively connected to the second reference voltage during the first voltage measurement phase.

Each analog to digital converter of the fault tolerant battery cell voltage measurement system may be configured to transmit a first phase voltage measurement and a second phase voltage measurement to the controller. The controller may be configured to receive input data, the input data comprising the first phase voltage measurement from each analog to digital converter and the second phase voltage measurement from each analog to digital converter. The controller may also be configured to analyze the input data to generate analyzed data, and to determine whether one of the plurality of analog to digital converters is faulty based on the analyzed data. In at least one example, the controller may analyze the input data at least in part by comparing a first phase voltage measurement of the first battery cell to a second phase voltage measurement of the first battery cell, and comparing a first phase voltage measurement of the second battery cell to a second phase voltage measurement of the second battery cell. For example, the controller may compare a first phase voltage measurement of the first battery cell received from the first analog to digital converter to a second phase voltage measurement of the first battery cell received from the second analog to digital converter, and determine whether the first phase voltage measurement of the first battery cell received from the first analog to digital converter is equal to the second phase voltage measurement of the first battery cell received from the second analog to digital converter. In some examples, the controller may further analyze the input data by comparing a second phase voltage measurement of a first reference voltage to a known voltage value of the first reference voltage.

In at least another aspect, a method of operating a fault tolerant battery cell voltage measurement system for measuring a plurality of voltages of a plurality of battery cells, respectively, is provided. The system may include the battery cells, or may not include the battery cells. The plurality of battery cells may include at least a first battery cell and a second battery cell. The system includes a plurality of analog to digital converters, a plurality of switches coupled to the plurality of analog to digital converters, the plurality of switches including a first set of switches and a second set of switches, and a controller.

The method includes closing the first set of switches by the controller to operatively connect a first subset of the plurality of battery cells to a first subset of the analog to digital converters during a first voltage measurement phase, and closing the second set of switches by the controller to operatively connect either the first subset or a second subset of the plurality of battery cells to a second subset of the analog to digital converters during a second voltage measurement phase. During conducting of the method, each of the battery cells of the plurality of battery cells is operatively connected to a respective first one of the plurality of analog to digital converters and a respective second one of the plurality of analog to digital converters, either successively during the first and second voltage measurement phases, respectively, or simultaneously during either of the first and second voltage measurement phases. Additionally, during conducting of the method, wherein at least one of the plurality of analog to digital converters is coupled to the first battery cell during the first voltage measurement phase and the second battery cell during the second voltage measurement phase.

The method may include transmitting a first phase voltage measurement from each analog to digital converter to the controller, and transmitting a second phase voltage measurement from each analog to digital converter to the controller. In at least some examples, the method may include measuring a voltage of the first battery cell using the first analog to digital converter during the first voltage measurement phase. The method may also include generating a first phase voltage measurement of the first battery cell by the first analog to digital converter. The method may further include transmitting the first phase voltage measurement from the first analog to digital converter to a controller. Similarly, in at least some examples, the method may include measuring a voltage of the first battery cell using the second analog to digital converter during the second voltage measurement phase. The method may also include generating a second phase voltage measurement of the first battery cell by the second analog to digital converter. The method may further include transmitting the second phase voltage measurement from the second analog to digital converter to the controller.

In at least one example, the method may include receiving by the controller the first phase voltage measurement of the first battery cell from the first analog to digital converter and the second phase voltage measurement of the first battery cell from the second analog to digital converter, and determining by the controller whether the first phase voltage measurement of the first battery cell received from the first analog to digital converter is equal to the second phase voltage measurement of the first battery cell received from the second analog to digital converter. With respect to the controller, the method may include receiving input data by the controller, the input data comprising the first phase voltage measurement from each analog to digital converter and the second phase voltage measurement from each analog to digital converter. The method may also include analyzing the input data by the controller to generate analyzed data. The method may further include determining by the controller whether one of the plurality of analog to digital converters is faulty based on the analyzed data. The analyzing of the input data by the controller may include comparing a first phase voltage measurement of the first battery cell to a second phase voltage measurement of the first battery cell, and comparing a first phase voltage measurement of the second battery cell to a second phase voltage measurement of the second battery cell. The analyzing the input data by the controller may further include comparing a second phase voltage measurement of a first reference voltage to a known voltage value of the first reference voltage.

One or more of the embodiments encompassed herein may be advantageous in any of a variety of respects. For example, the systems and methods described herein provide cell monitoring double redundancy, which may enable fault tolerance against single failure or multiple none-adjacent failures of analog to digital converters. Systems and methods in examples described above may also enable identification of a failing analog to digital converter within the monitoring system, as well as continued monitoring of all of the cells while disregarding the measurements of the failing analog to digital converter. This may reduce the amount of time that a battery pack is taken offline. Additionally, the number of battery cells in the plurality of battery cells may not be artificially constrained, since any number of analog to digital converters may be added.

While the principles of the invention have been described above in connection with specific apparatus, it is to be clearly understood that this description is made only by way of example and not as a limitation on the scope of the invention. It is specifically intended that the present invention not be limited to the embodiments and illustrations contained herein, but include modified forms of those embodiments including portions of the embodiments and combinations of elements of different embodiments as come within the scope of the following claims.

## Claims

1. A fault tolerant battery cell voltage measurement system for measuring a plurality of voltages of a plurality of battery cells, respectively, the plurality of battery cells including at least a first battery cell and a second battery cell, the system comprising:
a plurality of analog to digital converters;
a plurality of switches coupled to the plurality of analog to digital converters, the plurality of switches including a first set of switches and a second set of switches; and
a controller that is configured to close the first set of switches to operatively connect a first subset of the plurality of battery cells to a first subset of the analog to digital converters during a first voltage measurement phase, and to close the second set of switches to operatively connect either the first subset or a second subset of the plurality of battery cells to a second subset of the analog to digital converters during a second voltage measurement phase;
wherein each of the battery cells of the plurality of battery cells is operatively connected to a respective first one of the plurality of analog to digital converters and a respective second one of the plurality of analog to digital converters, either successively during the first and second voltage measurement phases, respectively, or simultaneously during either of the first and second voltage measurement phases; and
wherein at least one of the plurality of analog to digital converters is coupled to the first battery cell during the first voltage measurement phase and the second battery cell during the second voltage measurement phase.

2. The fault tolerant battery cell voltage measurement system of claim 1, wherein the system further comprises the plurality of battery cells.

3. The fault tolerant battery cell voltage measurement system of claim 1 or 2, wherein a first number of the analog to digital converters in the plurality of analog to digital converters is equal to a second number of the battery cells of the plurality of battery cells.

4. The fault tolerant battery cell voltage measurement system of claim 1 or 2, wherein a first number of the analog to digital converters in the plurality of analog to digital converters is equal to a second number of the battery cells of the plurality of battery cells plus one.

5. The fault tolerant battery cell voltage measurement system of any preceding claim, wherein:
the controller is configured to operatively connect, using at least a first switch of the first set of switches, the first battery cell to a least the first analog to digital converter during the first voltage measurement phase, and operatively connect, using at least a first switch of the second set of switches, the first battery cell to at least the second analog to digital converter during the second voltage measurement phase.

6. The fault tolerant battery cell voltage measurement system of any preceding claim, further comprising a first reference voltage, wherein the controller is further configured to operatively connect the first analog to digital converter to the first reference voltage during the second measurement phase.

7. The fault tolerant battery cell voltage measurement system of any preceding claim, further comprising a second reference voltage, wherein the controller is further configured to operatively connect the final analog to digital converter to the second reference voltage during the first voltage measurement phase.

8. The fault tolerant battery cell voltage measurement system of any preceding claim, wherein each analog to digital converter is configured to transmit a first phase voltage measurement and a second phase voltage measurement to the controller.

9. The fault tolerant battery cell voltage measurement system of claim 8, wherein the controller is configured to:
receive input data, the input data comprising the first phase voltage measurement from each analog to digital converter and the second phase voltage measurement from each analog to digital converter;
analyze the input data to generate analyzed data; and
determine whether one of the plurality of analog to digital converters is faulty based on the analyzed data.

10. The fault tolerant battery cell voltage measurement system of claim 9, wherein the controller is configured to analyze the input data at least in part by comparing a first phase voltage measurement of the first battery cell to a second phase voltage measurement of the first battery cell, and comparing a first phase voltage measurement of the second battery cell to a second phase voltage measurement of the second battery cell.

11. The fault tolerant battery cell voltage measurement system of claim 10, wherein the controller is configured to analyze the input data by further comparing a second phase voltage measurement of a first reference voltage to a known voltage value of the first reference voltage.

12. The fault tolerant battery cell voltage measurement system of any of claims 8 to 10, wherein the controller is configured to:
compare a first phase voltage measurement of the first battery cell received from the first analog to digital converter to a second phase voltage measurement of the first battery cell received from the second analog to digital converter; and
determine whether the first phase voltage measurement of the first battery cell received from the first analog to digital converter is equal to the second phase voltage measurement of the first battery cell received from the second analog to digital converter.

13. A method of operating a fault tolerant battery cell voltage measurement system for measuring a plurality of voltages of a plurality of battery cells, respectively, the plurality of battery cells including at least a first battery cell and a second battery cell, the system having:
a plurality of analog to digital converters;
a plurality of switches coupled to the plurality of analog to digital converters, the plurality of switches including a first set of switches and a second set of switches; and
a controller
the method comprising:
closing the first set of switches by the controller to operatively connect a first subset of the plurality of battery cells to a first subset of the analog to digital converters during a first voltage measurement phase; and
closing the second set of switches by the controller to operatively connect either the first subset or a second subset of the plurality of battery cells to a second subset of the analog to digital converters during a second voltage measurement phase;
wherein each of the battery cells of the plurality of battery cells is operatively connected to a respective first one of the plurality of analog to digital converters and a respective second one of the plurality of analog to digital converters, either successively during the first and second voltage measurement phases, respectively, or simultaneously during either of the first and second voltage measurement phases; and
wherein at least one of the plurality of analog to digital converters is coupled to the first battery cell during the first voltage measurement phase and the second battery cell during the second voltage measurement phase.

14. The method of claim 13, further comprising:
measuring a voltage of the first battery cell using the first analog to digital converter during the first voltage measurement phase;
generating a first phase voltage measurement of the first battery cell by the first analog to digital converter; and
transmitting the first phase voltage measurement from the first analog to digital converter to the controller.

15. The method of claim 14, further comprising:
measuring a voltage of the first battery cell using the second analog to digital converter during the second voltage measurement phase;
generating a second phase voltage measurement of the first battery cell by the second analog to digital converter; and
transmitting the second phase voltage measurement from the second analog to digital converter to the controller.
